**Europäisches Patentamt**

**European Patent Office**

**Office européen des brevets**

(19)

(11) Numéro de publication: **0 138 719**
**B1**

# (12) FASCICULE DE BREVET EUROPEEN

(45) Date de publication du fascicule du brevet: **18.01.89**

(21) Numéro de dépôt: **84402092.5**

(22) Date de dépôt: **18.10.84**

(51) Int. Cl.⁴: **H 01 L 39/12, H 01 L 39/24**

(54) Procédé d'élaboration de brins supraconducteurs multifilamentaires à partir de chalcogénure ternaire de molybdène.

(30) Priorité: **18.10.83 FR 8316537**

(43) Date de publication de la demande:
**24.04.85 Bulletin 85/17**

(45) Mention de la délivrance du brevet:
**18.01.89 Bulletin 89/03**

(84) Etats contractants désignés:
**BE CH DE FR GB IT LI NL SE**

(56) Documents cités:
**EP-A-0 073 128**
**DE-A-2 646 096**
**FR-A-2 483 118**

(73) Titulaire: **ALSTHOM**
**38, avenue Kléber**
**F-75784 Paris Cédex 16 (FR)**

(72) Inventeur: **Dubots, Patrick**
**1 Chemin de Gaillarbois**
**F-78640 Neauphle le Chateau (FR)**
Inventeur: **Renard, Jean-Claude**
**2, rue Molière**
**F-91380 Chilly Mazarin (FR)**

(74) Mandataire: **Weinmiller, Jürgen et al**
**Lennéstrasse 9 Postfach 24**
**D-8133 Feldafing (DE)**

Courier Press, Leamington Spa, England.

EP 0 138 719 B1

# Description

La présente invention est relative à un procédé d'élaboration de brins supraconducteurs multifilamentaires à partir de chalcogénure ternaire de molybdène, assemblés au sein d'une matrice stabilisatrice métallique, non supraconductrice, à base de cuivre, qui évacue la chaleur dégagée et constitue un shunt électrique pour les régions des filaments supraconducteurs ayant perdu leur état supraconducteur par suite d'un échauffement local.

Des tentatives sont faites pour réaliser des filaments supraconducteurs à partir de chalcogénures ternaires de molybdène de la forme $M_xMo_6X_8$ dans laquelle M peut être un élément 3d, un alcalin, alcalinoterreux, terres rares, argent, cadmium, indium, étain, plomb, x variant de 1 à 4 selon l'élément M et X étant un élément soufre, sodium, sélénium, tellure, couramment appelés "phases de Chevrel", en raison de leur champ critique extrêmement élevé, très supérieur à celui du niobium-titane. Elles ont porté pour l'essentiel sur le composé le plus performant $PbMo_6S_8$ mais elles n'ont pas permis d'atteindre les densités de courants critiques escomptées à partir des propriétés supraconductrices manifestées par les échantillons massifs.

Les phases de Chevrel ne sont pas ductiles en raison de leur structure cristallographique particulière et doivent être mises en oeuvre sous forme de poudre pour la réalisation de filaments supraconducteurs. Elles sont en outre polluées par le cuivre dont elles doivent être protégées par un gainage métallique approprié. Divers essais relatés notamment dans le document "Superconducting wires of $PbMo_{5,1}S_6$ by a powder technique", T. Luhman et D. Dew-Hughes, J. Appln. Phys. 49 (2), février 1978, P. 936—938, ont été faits en compactant une poudre de chalcogénure ternaire de molybdène dans des gaines d'argent, de molybdène ou de niobium entourées extérieurement de cuivre et tréfilées et étirées selon les techniques classiques de câblerie. Au cours de ces opérations la phase de Chevrel perd ses propriétés supraconductrices mais peut les récupérer au niveau des grains de poudre par un traitement thermique à 850—1000°C pendant une durée de quelques heures à quelques jours. La densité de courant au niveau d'un filament reste faible semble-t-il, en raison des porosités entre les grains de poudre. Ce défaut devrait pouvoir être éliminé par frittage mais la température exigée, supérieure à 1100°C est incompatible avec la présence de cuivre dans la matrice de stabilisation.

La présente invention a pour but de pallier le défaut précité et de parvenir à réaliser des brins supraconducteurs à base de phases de Chevrel présentant une densité de courant critique élevée sans pour autant nécessiter un traitement thermique final incompatible avec la présence de cuivre.

Elle a pour objet un procédé d'élaboration de brins supraconducteurs consistant à mélanger une poudre de chalcogénure ternaire de molybdène à propriétés supraconductrices avec une poudre métallique de granulométrie inférieure choisie parmi les composants du chalcogénure ternaire de molybdène considéré ou parmi le groupe de métaux constitué par l'aluminium, l'argent, le gallium, le rhénium et le titane, à gainer le mélange de poudre obtenu à l'aide d'une paroi métallique protégeant le chalcogénure ternaire de molybdène d'une pollution par le cuivre, ladite paroi métallique étant constituée à partir d'un groupe de métaux formé par le molybdène, le niobium, le tantale, le titane et le vanadium et à soumettre le brin supraconducteur obtenu après étirage et tréfilage selon les techniques classiques de câblerie au sein d'une matrice stabilisatrice à base de cuivre, à un traitement thermique final consistant en une cuisson à une température de l'ordre de 800°C pendant plusieurs dizaines d'heures.

La paroi métallique renfermant le mélange des poudres, et protégeant le chalcogénure ternaire de molybdène contre une pollution par le cuivre de la matrice stabilisatrice, est avantageusement revêtue intérieurement d'une couche métallique assurant un bon contact électrique choisie parmi le groupe de métaux constitué par l'aluminium, l'argent, le gallium, le rhénium et le titane.

D'autres caractéristiques et avantages de l'invention ressortiront de la description ci-après d'un exemple de réalisation d'un brin supraconducteur constitué de filaments supraconducteurs à base de phase de Chevrel du type $PbMo_6S_8$ additionnée de poudre d'argent réunis au sein d'une matrice stabilisatrice en cuivre.

La synthèse de la phase de Chevrel $PbMo_6S_8$ s'effectue à partir d'un mélange, en proportion stoechiométrique, des composants en poudre d'une granulométrie de 10 à 20 µm, comprimé, placé dans des tubes de silice scellés sous vide, portés à une température de l'ordre de 1400°C pendant une dizaine d'heures puis lentement refroidis.

Le produit fritté obtenu est ensuite broyé en une poudre présentant une granulométrie moyenne de l'ordre de 20 µm. A cette poudre de phase de Chevrel de type $PbMo_6S_8$ on mélange de la poudre d'argent d'une granulométrie moyenne de 1 µm dans une proportion pouvant atteindre plusieurs dizaines de pour cent. Le mélange de poudre, soigneusement réalisé par agitation de l'ensemble, est compacté, par exemple par voie isostatique pour réduire le taux de porosité. Ce compactage aboutit à des bâtonnets qui ont, par exemple un diamètre de l'ordre de 6 mm. Les bâtonnets sont alors introduits dans un tube de niobium de diamètre extérieur de 8 mm dont l'intérieur a été argenté sur une épaisseur de l'ordre de 10 µm. Le tout est introduit dans un tube de cuivre de diamètre extérieur de 10 mm. L'ensemble qui constitue "un étage 0" est mis sous vide et scellés hermétiquement puis tréfilé et étiré à froid.

Il peut être directement amené à un diamètre d'utilisation par exemple 0,3 mm et subir le traitement thermique final.

Il peut également être amené à un diamètre de l'ordre de 2,5 mm où il est tronçonné, les barreaux obtenus étant introduits dans un tube de cuivre de 10 mm de diamètre pour constituer un "étage 1" à nouveau mis sous vide, scellés thermétiquement, tréfilé et étiré à froid. Cette opération peut être répétée plusieurs fois pour constituer un brin à plusieurs dizaines ou plusieurs centaines de filaments supraconducteurs noyés dans une matrice stabilisatrice en cuivre.

Une fois le brin constitué et amené à son diamètre final, il subit un recuit de frittage et de régénération de la phase supraconductrice à une température de l'ordre de 800°C pendant quelques centaines d'heures.

La poudre d'argent ajoutée à la poudre de $PbMo_6S_8$ se place dans les porosités des grains de $PbMo_6S_8$ et diffuse dans ceux-ci au cours du traitement thermique final pour former à leurs zones de contact avec leurs composants non transformés, molybdène, soufre, une phase de Chevrel de type $Ag_{1,6}Mo_{6,4}S_8$ assurant la continuité supraconductrice entre grains.

Au lieu de poudre d'argent on peut utiliser une poudre de gallium connu comme dopant pour le $PbMo_6S_8$ ou d'aluminium, rhénium, titane connus pour ne pas dégrader les propriétés supraconductrices du $PbMo_6S_8$. On peut également utiliser une poudre de chacun des éléments constitutifs de la phase de Chevrel $PbMo_6S_8$, plomb, molybdène, soufre à condition que le produit de départ ayant donné le $PbMo_6S_8$ ait été été dosé hors proportion stoechiométrique de façon à rétablir celle-ci lors du mélange final des poudres.

Le tube de niobium joue le rôle d'une barrière anti-diffusion qui assure la protection de la phase de Chevrel vis-à-vis de cuivre. Il peut être remplacé par du molybdène, du tantale, du titane ou du vanadium.

L'argenture interne du tube de niobium qui joue le rôle d'une barrière de contact peut être remplacée par une couche d'un autre métal tel que l'aluminium, le gallium, le rhénium, le titane qui ne pollue pas la phase de Chevrel tout en assurant un bon contact électrique.

## Revendications

1. Procédé d'élaboration de brins supraconducteurs multifilamentaires à partir de chalcogénure ternaire de molybdène, assemblés au sein d'une matrice stabilisatrice métallique non supraconductrice, à base de cuivre, consistant à:

— mélanger une poudre de chalcogénure ternaire de molybdène à propriétés supraconductrices avec une poudre métallique de granulométrie inférieure choisie parmi les composants du chalcogénure ternaire de molybdène considéré ou parmi le groupe de métaux constitué par l'aluminium, l'argent, le gallium, le rhénium, le titane,

— gainer le mélange de poudre obtenu à l'aide d'une paroi métallique protégeant le chalcogénure ternaire de molybdène d'une pollution par le cuivre, ladite paroi métallique étant constituée à partir d'un groupe de métaux formé par le molybdène, le niobium, le tantale, le titane et le vanadium,

— et soumettre le brin supraconducteur obtenu après étirage et tréfilage selon les techniques classiques de câblerie au sein d'une matrice stabilisatrice à base de cuivre, à un traitement thermique final consistant en une cuisson à une température de l'ordre de 800°C pendant plusieurs dizaines d'heures.

2. Procédé selon la revendication 1, caractérisé en ce que ladite paroi métallique renfermant le mélange des poudres et protégeant le chalcogénure ternaire de molybdène contre une pollution par le cuivre est revêtue intérieurement d'une couche métallique choisie parmi le groupe de métaux constitué par l'aluminium, l'argent, le gallium, le rhénium et le titane.

3. Procédé selon la revendication 1, caractérisé en ce que la poudre de chalcogénure ternaire de molybdène est de type $PbMo_6S_8$ et la poudre métallique une poudre d'argent.

4. Procédé selon la revendication 3, caractérisé en ce que la paroi métallique protégeant le mélange de poudre de chalcogénure ternaire de molybdène de type $PbMo_6S_8$ et de poudre d'argent est revêtue intérieurement d'une couche d'argent.

5. Procédé selon la revendication 3, caractérisé en ce que la paroi métallique protégeant le mélange de poudre de chalcogénure ternaire de molybdène de type $PbMo_6S_8$ et de poudre d'argent est en niobium.

## Patentansprüche

1. Verfahren zur Herstellung von mehrlitzigen supraleitenden Kabeln aus ternären Molybdänchalcogenid, die in eine nichtsupraleitende, stabilisierende metallische Matrix auf Kupferbasis eingebettet sind, bestehend aus den folgenden Schritten:

— Mischen eines Pulvers aus ternärem Molybdänchalcogenid mit supraleitenden Eigenschaften mit einem Metallpulver kleinerer Korngrößen, ausgewählt aus den Komponenten des in Betracht gezogenen ternären Molybdänchalcogenids oder aus der Gruppe der Metalle Aluminium, Silber, Gallium, Rhenium, Titan;

— Einhüllen der erhaltenen Pulvermischung mit einer Metallwand, die das ternäre Molybdänchalcogenid gegen Verunreinigung durch Kupfer schützt, wobei die Metallwand aus einer Gruppe von Metallen gebildet ist, die aus Molybdän, Niobium, Tantal, Titan und Vanadium besteht;

— und Wärmebehandlung des nach dem Strecken und Drahtziehen mittels der konventionellen Kabelherstellungstechniken in einer stabilisierenden Matrix auf Kupferbasis erhaltenen supraleitenden Kabels, und zwar bei einer Temperatur von etwa 800°C mehrer -zig Stunden lang.

2. Verfahren nach Anspruch 1, dadurch gekennzeichnet, daß die das Pulvergemisch umschließende und das ternäre Molybdänchalcogenid gegen Verunreinigung durch Kupfer schützende Metallwand an der Innenseite mit einer Metallschicht überzogen ist, die aus der Gruppe der Metalle Aluminium, Silber, Gallium, Rhenium und Titan gewählt ist.

3. Verfahren nach Anspruch 1, dadurch gekennzeichnet, daß das ternäre Molybdänchalcogenidpulver vom Typ PbMo$_6$S$_8$ und das Metallpulver ein Silberpulver ist.

4. Verfahren nach Anspruch 3, dadurch gekennzeichnet, daß die das Gemisch aus ternärem Molybdänchalcogenidpulver vom Typ PbMo$_6$S$_8$ und Silberpulver schützende Wand an der Innenseite mit einer Silberschicht bedeckt ist.

5. Verfahren nach Anspruch 3, dadurch gekennzeichnet, daß die das Gemisch aus ternärem Molybdänchalcogenidpulver vom Typ PbM$_6$S$_8$ und Silberpulver schützende Wand aus Niobium ist.

**Claims**

1. A method of making multifilament superconducting cables from ternary molybdenum chalcogenide assembled with a non-superconducting stabilizing copper based metal matrix, consisting in:

— mixing a ternary molybdenum chalcogenide powder having superconducting properties with a metal powder having a smaller grain size and being chosen from the components of the considered ternary molybdenum chalcogenide or from the group of metals constituted by aluminium, silver, gallium, rhenium and titanium;

— sheathing the obtained powder mixture with a metal wall capable of protecting the ternary molybdenum chalcogenide against a pollution with copper, said metal wall being made from a group of metals constituted by molybdenum, niobium, tantalum, titanium and vanadium,

— and subjecting the superconducting cable obtained after stretching and wire-drawing according to the conventional techniques of cable-making within a copper based stabilizing matrix to a final heat treatment which consists in a baking run at a temperature of about 800°C for a period of several tens of hours.

2. A method according to claim 1, characterized in that said metal wall enclosing the mixture of powders and protecting the ternary molybdenum chalcogenide from copper pollution is coated at the inside with a layer of metal chosen from the group of metals constituted by aluminium, silver, gallium, rhenium and titanium.

3. A method according to claim 1, characterized in that the ternary molybdenum chalcogenide powder is of the PbMo$_6$S$_8$ type and the metal powder is silver powder.

4. A method according to claim 3, characterized in that the metal wall protecting the mixture of the ternary molybdenum chalcogenide powder of the PbMo$_6$S$_8$ type and the silver powder is coated at the inside with a layer of silver.

5. A method according to claim 3, characterized in that the metal wall protecting the mixture of the ternary molybdenum chalcogenide powder of the PbMo$_6$S$_8$ type and the silver powder is made of niobium.